(19) Europäisches Patentamt
European Patent Office
Office européen des brevets

(11) Publication number: 0 061 689 B1

(12) **EUROPEAN PATENT SPECIFICATION**

(45) Date of publication of patent specification: 27.08.86

(51) Int. Cl.$^4$: G 03 F 7/10

(21) Application number: 82102359.5

(22) Date of filing: 22.03.82

# (54) Radiation sensitive polymer materials.

(30) Priority: 27.03.81 JP 44032/81
17.08.81 JP 127811/81

(43) Date of publication of application:
06.10.82 Bulletin 82/40

(45) Publication of the grant of the patent:
27.08.86 Bulletin 86/35

(84) Designated Contracting States:
DE GB NL

(56) References cited:
FR-A-2 286 414
JP-A-55 017 112
CHEMICAL ABSTRACTS, vol.94, no.4, February 1981, page 582, abstract no.55833v, Columbus, Ohio (US) K. SUGITA et al.: "Application of photodegradable polymers"
IBM TECHNICAL DISCLOSURE BULLETIN, vol.18, no.7, December 1975, New York (US) R. FEDER et al.: "Doped resist for electrons and X-rays with enhanced sensitivity", pages 2343-2345

(73) Proprietor: Hitachi, Ltd.
5-1, Marunouchi 1-chome
Chiyoda-ku Tokyo 100 (JP)

(72) Inventor: Nate, Kazuo
1670-115, Naruse
Machida-shi (JP)
Inventor: Kobayashi, Toshio Meitsu Shinagawa
1-9-205, Higashi-Shinagawa-1-chome
Shinagawa-ku Tokyo (JP)
Inventor: Isogai, Tokio
3941-1, Aza Karaike Fujisawa
Fujisawa-shi (JP)
Inventor: Yokono, Hitoshi
8-5, Chuocho
Katsuta-shi (JP)

(74) Representative: Patentanwälte Beetz sen. - Beetz jun. Timpe - Siegfried - Schmitt-Fumian
Steinsdorfstrasse 10
D-8000 München 22 (DE)

(56) References cited:
J. ELECTROCHEMICAL SOC., vol.128, no.6, June 1981, Manchester, New. Hampshire (US) K. NATE et al.: "Poly p-substituted isopropenyl ketones for positive photoresists", pages 1394-1395

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 061 689 B1

**Description**

The present invention relates to radiation sensitive polymers and polymer compositions of the positive type having high radiation sensitivity.

The manufacture of integrated circuits of high integration density necessitates fine resist patterns having a line width of less than 1 µm. For the formation of these fine resist patterns, radiation sensitive resists sensitive to electron beams, X-rays and ion beams are used.

There are two types of radiation sensitive resists, namely the negative type and the positive type.

Radiation sensitive resists of the negative type can, because of their reaction mechanism, inherently withstand influences caused by dry etching which is conducted at the time of fine pattern formation, and have a good sensitivity but only a poor resolution.

On the other hand, radiation sensitive resists of the positive type are inherently better in resolution than the negative type, because of their reaction mechanism. However, these positive type resists are attacked at the pattern edges in the dry etching step, and are poorer in sensitivity than the negative type resists.

The FR—A—22 86 414 discloses positive type photoresists on the basis of a polymer comprising repeating units derived from an isopropenyl ketone and eventually repeating units derived from a copolymerizable vinyl monomer. The preferred photosensitive polymer is poly(methy-isopropenyl ketone), and it is only shortly mentioned (page 1, lines 36 to 38) that the methyl groups can be replaced by an aryl group, however, these aryl groups are not specified at all and only methyl isopropenyl ketone is used in the examples.

Although the photosensitive polymers of FR—A 22 86 414 have a relatively high sensitivity, the dry etching resistance is poor.

In this connection it was surprising that homo- and copolymers of eventually p-substituted phenyl isopropenyl ketones lead to a high radiation sensitivity and simultaneously to an excellent dry etching resistance. Furthermore, the use of metal halides or nitrates as an additional component gives a further improvement of the sensitivity.

It is an object of this invention to provide radiation sensitive polymers and compositions for positive type resists which overcome the disadvantages of the prior art and lead to at least the same resolution as conventional positive type resists and have improved sensitivity and dry etching resistance comparable to the sensitivity and etching resistance of conventional negative type resists.

The above object is achieved according to the claims 1 and 2.

The radiation sensitive polymers according to the invention comprise

(A) repeating units derived from an aryl isopropenyl ketone and possibly

(B) repeating units derived from a copolymerizable vinyl monomer,

and are characterized by

— 10 to 100 mole-% of one or more repeating units (A) of the formula I

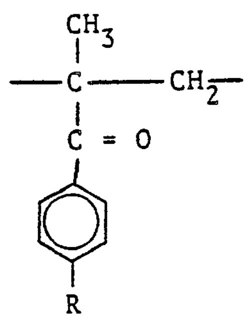

(I),

wherein R is H, $-CH_3$, $-OCH_3$, Cl, Br, J or $-N(CH_3)_2$,

and

— 90 to 0 mole-% of repeating units (B) derived from methacryclic acid, methyl methacrylate, methacrylonitrile or methyl isopropenyl ketone.

The radiation sensitive polymer compositions according to the invention comprise

(1) 80 to 99,9 % by weight of the above defined radiation sensitive polymer and

(2) 0,1 to 20 % by weight of $AlCl_3 \cdot 6H_2O$, $CaCl_2 \cdot 6H_2O$, $CoCl_2.6H_2O$, $FeCl_3 \cdot 6H_2O$, $CuCl_2 \cdot 2H_2O$, $NiCl_2 \cdot 2H_2O$, $PdCl_2 \cdot 2H_2O$, $MnCl_2 \cdot 4H_2O$, $CrCl_3 \cdot 6H_2O$, $Al(NO_3)_3 \cdot 9H_2O$, $Zn(NO_3)_2 \cdot 6H_2O$, $In(NO_3)_3 \cdot 3H_2O$, $Ca(NO_3)_2 \cdot 4H_2O$, $Cr(NO_3)_3 \cdot 9H_2O$, $Co(NO_3)_2 \cdot 6H_2O$, $Fe(NO_3)_3 \cdot 9H_2O$, $Cu(NO_3)_2 \cdot 3H_2O$, $Ni(NO_3)_2 \cdot 6H_2O$ or $Mn(NO_3)_2 \cdot 6H_2O$.

The radiation sensitive polymer compositions according to the invention

— 90 to 99,9 % by weight of component (1)

and

— 0,1 to 10 % by weight of component (2)

When these polymers or copolymers comprising repeating units (A) of the formula I are irradiated with electron beams, X-rays or ion beams, an effective degradation of their molecular chains occurs, which leads to an improved sensitivity . Furthermore, they are less susceptible to attack in dry etching. The sensitivity is further improved when the monomer units (A) possess substituents in the para-position of the aromatic rings. The sensitivity can be further improved to a large extent when the radiation sensitive polymers are used together with hydrates of metal chlorides or metal nitrates in the corresponding polymer compositions.

When the comonomer units (B) are present in the polymer in an amount of more than 90 mole-%, the sensitivity of the polymer to radiation such as electron beam, X-rays, ion beam, etc., becomes inferior, and the resistance to dry etching is remarkably lowered.

When, on the other side, the component (2), i.e. the metal chloride or nitrate hydrate, is present in the compositions in an amount of less than 0,1 % by weight, the sensitivity of the compositions is not additionally improved. When the amount of the component (2) exceeds 20 % by weight, the sensitivity is reduced.

Preferable examples of the repeating units (A) represented by the formula I are

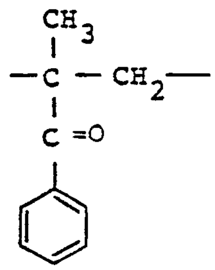 , 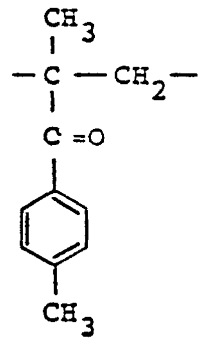 , 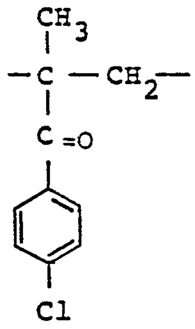 , 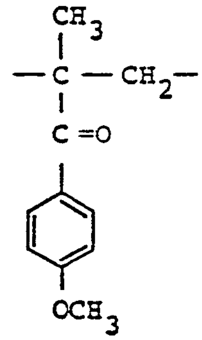 , etc.

These repeating units (A) may be present in the polymer singly or in combination of two or more of them.

The comonomer units (B) are derived from methacrylic acid methyl methacrylate, methacrylonitrile or methyl isopropenyl ketone, Each of these compounds can be used alone.

Preferred examples of the polymer having repeating units (A) and (B) are:

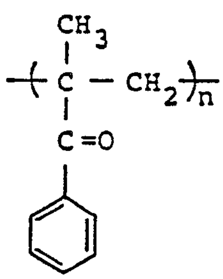

(molecular weight (MW) 50,000)

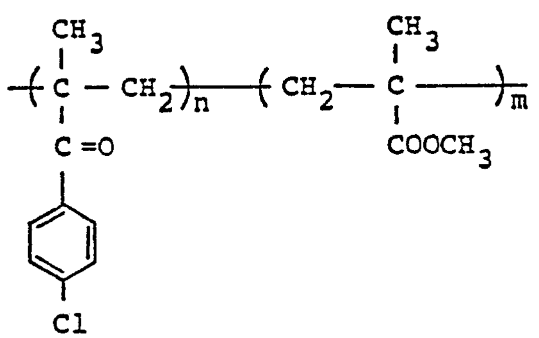

(MW 80,000, copolymerization ratio (CPR) 0.5/0.5)

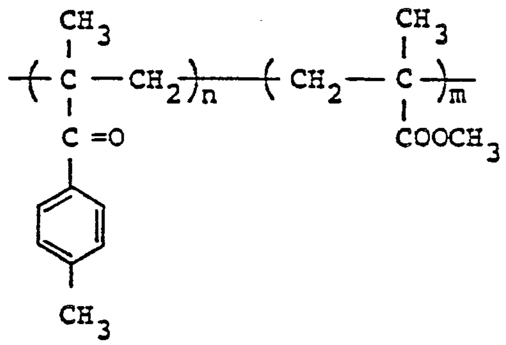

(MW 30,000, CPR 0.5/0.5)

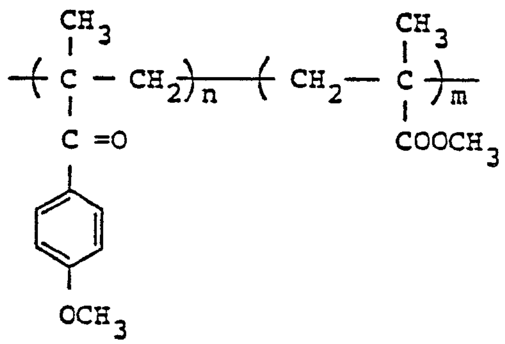

(MW 50,000, CPR 0.5/0.5)

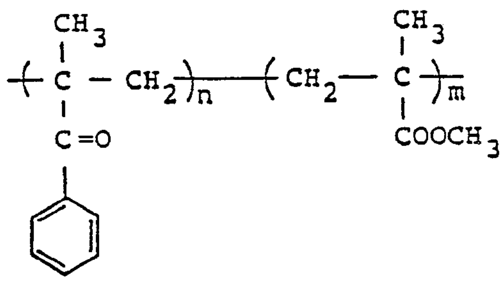

(MW 10,000, CPR 0.8/0.2)

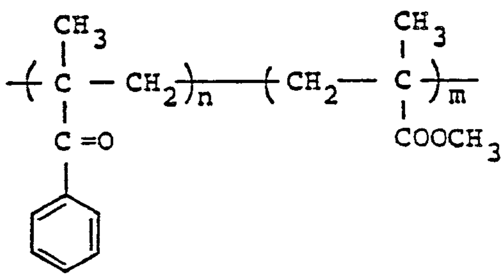

(MW 80,000, CPR 0.1/0.9)

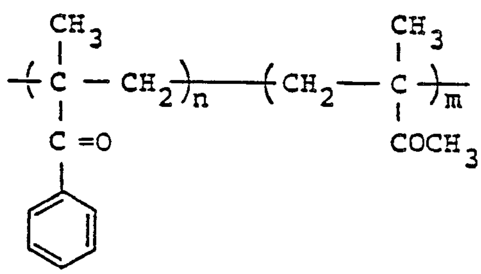

(MW 30,000, CPR 0.5/0.5)

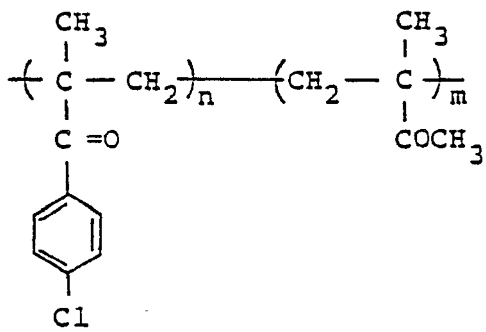

(MW 10,000, CPR 0.8/0.2)

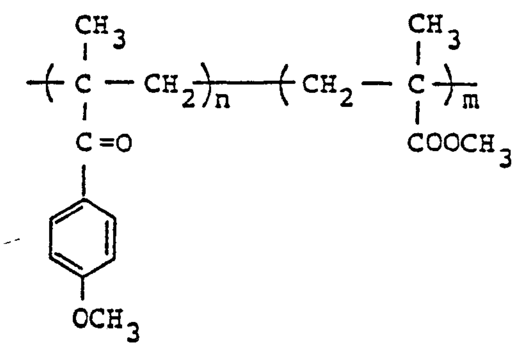

(MW 70,000, CPR 0.3/0.7)

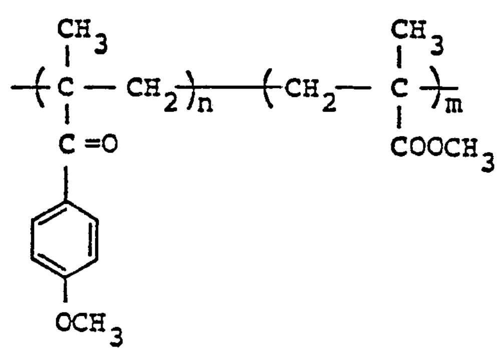

(MW 100,000, CPR 0.2/0.8)

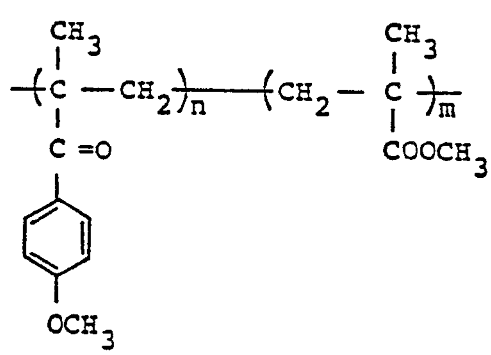

(MW 150,000, CPR 0.12/0.88)

The polymer of component (1) having the repeating units (A) and (B) itself has good radiation sensitivity. By adding the component (2) in the defined amounts the sensitivity is further improved effectively.

The polymers and polymer compositions according to the invention are used as positive type resist materials. For this purpose, they are dissolved in a conventional organic solvent such as toluene, methyl isobutyl ketone, N-methylpyrrolidine and the like.

The solubility of the polymer compositions in the above organic solvent can be improved by adding an organic acid such as maleic acid, citraconic acid and the like.

Hereinafter, the present invention is further explained in detail with reference to examples. The starting materials used for preparing organic polymers according to the invention were synthesized as follows.

Synthesis Example 1

13,4 g of propiophenone, 4,5 g of paraformaldehyde, 12,2 g of piperidine hydrochloride, 0,25 ml of concentrated hydrochloric acid and 50 ml of ethanol were mixed. The mixture was refluxed for about 1 h, and after addition of another 4,5 g of paraformaldehyde, the whole mixture was further refluxed for about 2 h. The resulting mixture was recrystallized from an acetone-ethanol solution to obtain phenyl β-piperidino isopropyl ketone hydrochloride (white, needle-like crystals).

Next, 10 g of this salt were heated at 200°C for 3 h in 50 ml of N-methylpyrrolidone. After cooling and washing, phenyl isopropenyl ketone was obtained by distillation under reduced pressure (b.p.: 35 to 50°C/1,3 hPa).

Synthesis Example 2

In a 1-liter three-necked flask were placed 92 g of toluene, 300 ml of carbon disulfide and 147 g of anhydrous aluminum chloride powder. Subsequently, 130 g of propionic acid anhydride were added dropwise in about 1 h with mechanical stirring. The resulting mixture was refluxed for 3 h until the generation of HCl gas had ceased. After cooling the reaction solution was transferred into 500 ml of an icewater mixture, and the organic solvent layer was extracted with ether.

The ether layer was washed with water, dried in a usual manner to remove the water and distilled under reduced pressure to obtain p-methylpropiophenone (bp.: 85 to 90°C/5,3 hPa).

Next, 14,8 g of p-methyl-propiophenone, 4,5 g of paraformaldehyde, 12,2 g of piperidine hydrochloride, 0,25 ml of concentrated hydrochloric acid and 50 ml of absolute ethanol were mixed. The mixture was refluxed for about 1 h and, after further addition of 3,0 g of paraformaldehyde, the whole mixture was refluxed for about 3 h. After cooling, the above reaction solution was re-crystallized from an acetone-ethanol solution as in Synthesis Example 1, to obtain α-piperidinomethyl-p-methylpropiophenone hydrochloride white, needle-like crystals. Subsequently, 26,8 g of the above salt and 12,3 g of potassium t-butoxide were refluxed for about 5 h in 100 ml of t-butanol.

Next, 200 ml of water were added to the above reaction solution. The mixture was extracted with ether and the extract was dried over a desiccating agent and distilled under reduced pressure to obtain p-methylphyl isopropenyl ketone (b.p.: 70 to 80°C/1,3 to 2,7 hPa).

Synthesis Example 3

In a 1-liter three-necked flask were placed 108 g of anisole, 300 ml of carbon disulfide and 147 g of anhydrous aluminum chloride powder. Subsequently 130 g of propionic and anhydride were added dropwise in about 1 h with mechanical stirring. The whole mixture was refluxed for 5 h until the generation of HCl gas had ceased. After cooling the reaction solution was subjected to the same procedure as described in Synthesis Example 2 to obtain p-methoxy-propiophenone (b.p.: 115 to 118°C/5,3 hPa).

Next, there were mixed 16,4 g of p-methoxy-propiophenone, 4,5 g of paraformaldehyde, 12,2 g of piperidine hydrochloride, 0,25 ml of concentrated hydrochloric acid and 50 m. of absolute ethanol. This mixture was refluxed for about 1 h and, after further addition of 3,0 g of paraformaldehyde, the whole mixture was refluxed for about 5 h. Subsequently, this reaction solution was recrystallized from an acetone-ethanol solution to obtain α-piperidinomethyl-p-methooxypropiophenone hydrochloride (white, needle-like crystals).

Subsequently, 28,4 g of the above salt and 12,3 g of potassium t-butoxide were refluxed for about 4 h in 100 ml of t-butanol. After cooling, this mixture was distilled under reduced pressure to give p-methoxyphenyl isopropenyl ketone (b.p.: 113 to 115°C/2,7 hPa).

Synthesis Example 4

p-Chlorophenyl isopropenyl ketone, p-bromophenyl isopropenyl ketone and p-iodophenyl isopropenyl ketone were synthesized by using the same procedures as described in Synthesis Example 1 to 3. Namely, firstly p-halogenated propiophenone was synthesized by Friedel-Crafts reaction by using propionyl chloride instead of propionic anhydride. Subsequently, white crystals of α-piperidinomethyl-p-halogenated propiophenone hydrochloride were obtained by Mannich reaction. Finally, the p-halogenated phenyl isopropenyl ketone was obtained by deamination reaction.

Example 1

Using 0,1 g of azobisisobutyronitrile as polymerization initiator, 10 g of pheny isopropenyl ketone

obtained in Synthesis Example 1 were polymerized at 80°C for 10 h in a sealed tube containing nitrogen gas.

The polymer obtained was dissolved in about 10 ml of methyl isobutyl ketone. The solution obtained was transferred into about 500 ml of methanol to give a white precipitate of the above polymer. The weight average molecular weight of the polymer determined by liquid chromatography was about 50.000 (standard polystyrene).

The polymer was dissolved in methyl isobutyl ketone to obtain a resist solution wherein the solid polymer content was 15% by weight. Subsequently, this solution was spin-coated on to a silicon wafer at a rotation speed of 2000 $min^{-1}$ to form a polymer film of 0,8 μm thickness.

The wafer was prebaked at 150°C for 30 min and then transferred to an electron beam irradiation apparatus wherein an electron beam at an acceleration voltage of 15 kV was scanned over the wafer in vacuo so as to irradiate different dosages to different portions. Then, the wafer was taken out from the apparatus and dipped for 2 min in a developer consisting of methyl isobutyl ketone and isopropanol (35:65 by volume) for development. The developed wafer was then rinsed with isopropanol to dissolve the irradiated portions. The dosage dependent thickness of the polymer film in different portions was measured by the use of a thin film level difference meter. The film thickness in the respective portions after development (normalized) was plotted versus the irradiated electron beam energy (exposure dose) (C/$cm^2$), whereby the electron beam sensitivity curve shown in the attached drawing was obtained. The minimum exposure dose giving a film thickness of zero obtained from the diagram was $6°10^{-6}$ C/$cm^2$. Thus, the polymer of the present invention had a sensitivity 10 times or more as high as that of, for example, poly(methyl methacrylate).

Subsequently, the wafer was subjected to ion etching under an argon gas pressure of 0,53 Pa and at an ion energy density of 0,25 W/$cm^2$. The polymer of the present invention showed an ion etching rate of 15 nm/min compared to 20 nm/min in the case of a silicon oxide film. This indicates that etching of the substrate becomes possible by using a resist film according to the present invention having a thickness of at least two times that of the silicon oxide film, with consideration of the non-uniformity of etching and other parameters.

## Example 2

Using 0,1 g of azobisisobutyronitrile as a polymerization initiator, 8 g of p-chlorophenyl isopropenyl ketone obtained in Synthesis Example 4 and 5 g of methyl methacrylate were polymerized at 80°C for 6 h in a sealed tube containing nitrogen gas. The copolymer obtained was recovered in the same mannner as described in Example 1 to obtain a white precipitate. The determination by liquid chromatography revealed that the copolymer had a weight average molecular weight of about 80.000 (standard polystyrene). Further, the NMR spectrum of this copolymer in an acetone-$d_6$ solution revealed that it contained 50% by mole of p-chlorophenyl isopropenyl ketone.

The copolymer was dissolved in methyl isobutyl ketone to obtain a resist solution containing 15% by weight of the copolymer. In the same manner as described in Example 1, a polymer film of 1,0 μm thickness was formed on a silicon wafer by spin coating at a rotation speed of 2000 $min^{-1}$.

The silicon wafer was prebaked at 150°C for 30 min. Then, the wafer was irradiated with soft X-rays of a wavelength of 0,54 nm from a molybdenum anticathode tube (rotational water cooling type; acceleration voltage 10 kV, 500 mA) with locally different exposure doses under a vacuum of 0,13 Pa.

The irradiated wafer was dipped into a developer consisting of methyl isobutyl ketone and isopropanol (35:65 by volume) for 2 min for development. Then, the wafer was rinsed with isopropanol to dissolve the irradiated portions.

In the same manner as described in Example 1, the resulting film thickness after development (normalized) was plotted versus the exposure dose. From the curve obtained, the minimum exposure dose giving a film thickness of zero was found to be 30 mJ/$cm^2$. This fact indicates that the above resist had a high sensitivity such as a positive type resist. Also, ion etching was carried out under argon gas in the same manner as in Example 1. This polymer gave an ion etching rate of 17 nm/min which showed the excellent ion etching resistance of the polymer.

## Example 3

Using the same procedures as described in Examples 1 and 2, polymers of various compositions (polymers 1 to 9 in Table 1) were obtained by radical polymerization at 80°C for 10 h using azobisisobutyronitrile as a polymerization initiator. The polymers were recovered in the same manner as described in Example 1. Then, the polymers 1, 2, 3, 5, 6 and 7 were dissolved in methyl isobutyl ketone to give 15% by weight solutions, and the polymers 4, 8 and 9 were dissolved in toluene to give 10% by weight solutions. Each polymer solution obtained was applied onto a silicon wafer by spin coating to form a polymer film of about 1 μm thickness.

Subsequently, the sensitivity of each polymer-coated wafer to an electron beam (acceleration voltage 15 kV) was measured. Also, the ion etching resistance of each polymer film was measured via the ion etching speed by ion etching under argon gas. These results are summarized in Table 1.

As may be seen from Table 1, all positive type resists showed high radiation sensitivity and excellent dry etching resistance.

TABLE 1

| Polymer No. | Kind of polymer material * | Molecular weight | Developer | Sensitivity ($\mu C/cm^2$) | Ion etching rate (nm /min.) |
|---|---|---|---|---|---|
| 1 | p-Methylphenyl isopropenyl ketone [50] /methyl methacrylate [50] copolymer | 30.000 | Methyl isobutyl ketone /isopropanol (50/50 by volume) | 3 | 19 |
| 2 | p-Methoxyphenyl isopropenyl ketone [50] /methyl methacrylate [50] copolymer | 50.000 | do. | 2 | 18 |
| 3 | Phenyl isopropenyl ketone [80] /methyl methacrylate [20] copolymer | 10.000 | Methyl isobutyl ketone /isopropanol (20/80 by volume) | 5 | 16 |
| 4 | Phenyl isopropenyl ketone [10] /methyl methacrylate [90] copolymer | 80.000 | Methyl isobutyl ketone /isopropanol (35/65 by volume) | 9 | 21 |
| 5 | Phenyl isopropenyl ketone [50] /methyl isopropenyl ketone [50] copolymer | 30.000 | do. | 8 | 19 |
| 6 | p-Chlorophenyl isopropenyl ketone [80] /methyl isopropenyl ketone [20] copolymer | 10.000 | do. | 7 | 17 |
| 7 | p-Methoxyphenyl isopropenyl ketone [30] /methyl methacrylate [70] copolymer | 70.000 | Methyl isobutyl ketone /isopropanol (60/40 by volume) | 1 | 19 |
| 8 | p-Methoxyphenyl isopropenyl ketone [20] /methyl methacrylate [80] copolymer | 100.000 | do. | 3 | 20 |
| 9 | p-Methoxyphenyl isopropenyl ketone [12] /methyl methacrylate [88] copolymer | 150.000 | do. | 10 | 21 |

+ Values in [ ] in this column represent the comonomer mole percentages in the respective copolymers. These values were obtained from NMR spectra.

Example 4

In a sealed tube containing nitrogen gas, 8 g of phenyl isopropenyl ketone obtained in Synthesis Example 1, 5 g of methyl methacrylate and 0,1 g of azobisisobutyronitrile were polymerized at 60°C for 10 h. The copolymer obtained was dissolved in 10 ml of methyl isobutyl ketone. The solution obtained was poured into 1000 ml of methanol to obtain a white precipitate.

The measurement by liquid chromatography revealed that the copolymer obtained had a weight average molecular weight of about 80.000 (standard polystyrene).

The NMR-spectrum of the copolymer dissolved in acetone-$d_6$ confirmed that the copolymer contained 40% by mole of phenyl isopropenyl ketone.

For preparing a resist solution the copolymer was dissolved in methyl isobutyl ketone to give a 15% by weight solution. To this solution was added an acetone solution containing 10% by weight of indium nitrate trihydrate so that the indium nitrate content became 10% by weight based on the weight of the copolymer.

This resist solution was applied on to a silicon wafer by spin coating at a rotation speed of 2000 $min^{-1}$ to form a polymer film on the wafer. Subsequently, the wafer was prebaked at 150°C for 30 min. The prebaked wafer was placed in an electron beam irradiation apparatus, wherein an electron beam at an acceleration voltage of 20 kV was scanned over the wafer so as to irradiate different dosages to different portions. Then, the irradiated wafer was taken out from the apparatus and dipped in a developer consisting of methyl isobutyl ketone and isopropanol (70 : 30 by volume) for 2 min for development. The developed wafer was rinsed with isopropanol to dissolve the irradiated portions. The thickness of the polymer film was measured at various portions irradiated with different dosages by a thin film level difference meter as in Example 1.

The film thickness in the respective portions after development (normalized) was plotted versus the exposure dose ($C/cm^2$), whereby the electron beam sensitivity curve was obtained. From the curve, the minimum exposure dose giving a film thickness of zero was found to be $1,5 \cdot 10^{-6} C/cm^2$. Thus, the above copolymer had excellent electrone sensitivity, for instance, about 50 times as high as that of poly(methyl methacrylate) and at least 5 times that of the polymer without additive.

The resist of the present invention showed good spin coating properties and excellent solvent resistance as well as good resolving power so that lines and spaces of 0,5 µm or less could be resolved.

Example 5

In the presence of 0,1 g of azobisisobutyronitrile, 5 g of p-methylphenyl isopropenyl ketone obtained in Synthesis Example 2 and 6 g of methyl methacrylate were bulk polymerized at 40°C for 20 h. After recovering similarly to Example 1, a copolymer was obtained.

The NMR spectrum revealed that the copolymer contained 25% by mole of p-methylphenyl isopropenyl ketone. The liquid chromatography revealed that the copolymer had a weight average molecular weight of about 70.000 (standard polystyrene).

For preparing a resist, the copolymer was dissolved in methyl isobutyl ketone to obtain a 15% by weight solution. To this solution were added an acetone solution containing 10% by weight of palladium chloride dihydrate and an acetone solution containing 10% by weight of citraconic acid so that palladium chloride and citraconic acid became 5% by weight, respectively, based on the weight of the copolymer.

This resist solution was applied onto a silicon wafer by spin coating at a rotation speed of 2000 $min^{-1}$ to obtain a polymer film of 1,1 µm thickness.

Subsequently, the wafer was prebaked at 150°C for 30 min. The prebaked wafer was irradiated with soft X-rays of a wavelength of 0,83 nm from an aluminum anticathode tube (rotational water cooling type; acceleration voltage 10 kV) with locally different exposure doses. The irradiated wafer was developed by dipping for 2 min in a developer consisting of methyl isobutyl ketone and isopropanol (70 : 30 by volume). By rinsing with isopropanol, the irradiated portions of the copolymer film were dissolved. Similarly to Example 1, the resulting film thickness after development (normalized) was plotted versus the exposure dose. From the curve thus obtained, the minimum exposure dose giving a film thickness of zero was found to be 10 $mJ/cm^2$. Accordingly, this copolymer had a high X-ray sensitivity. Also the copolymer showed good spin coating properties and good adhesiveness.

Example 6

Polymers of various compositions shown in Table 2 were obtained by radical polymerization at 60°C for 10 h using azobisisobutyronitrile as a polymerization initiator. Each polymer obtained was recovered similarly to Example 4, and the polymers were dissolved in methyl isobutyl ketone to obtain 15% by weight solutions. To these solutions was added an additive in a predetermined quantity to give the compositions 10 to 27 shown in Table 2. Each resulting solution was applied on to a silicon wafer by spin coating to give a polymer film of about 1 µm thickness.

Then, the sensitivity of these films to an electron beam at an acceleration voltage of 20 kV was determined. The results were shown in Table 2. The results show that all polymers had a high radiation sensitivity.

TABLE 2

| Compos. No. | Kind of polymer | Additive [wt.—%] | Developer [vol.—%] | Sensitivity ($\mu C/cm^2$) |
|---|---|---|---|---|
| 10 | p-Methoxyphenyl isopropenyl ketone [50] /methyl methacrylate [50] copolymer | $Cr(NO_3)_3 \cdot 9H_2O$ [10] | Methyl isobutyl ketone [70] /isopropanol [30] | 1,5 |
| 11 | do. | $Co(NO_3)_2 \cdot 6H_2O$ [1] | do. | 2 |
| 12 | Phenyl isopropenyl ketone [10] /methyl methacrylate [90] copolymer | $FeCl_3 \cdot 6H_2O$ [20] | Methyl isobutyl ketone [50] /isopropanol [50] | 4 |
| 13 | do. | $FeCl_3 \cdot 6H_2O$ [10] | do. | 6 |
| 14 | do. | $FeCl_3 \cdot 6H_2O$ [0.1] | do. | 7 |
| 15 | p-Chlorophenyl isopropenyl ketone [90] /methacrylic acid [10] copolymer | $Ni(NO_3)_2 \cdot 6H_2O$ [5] | Methyl isobutyl ketone [50] /xylene [50] | 0,9 |
| 16 | Phenyl isopropenyl ketone [99] /methacrylic acid [1] copolymer | $In(NO_3)_3 \cdot 3H_2O$ [10] | do. | 3 |
| 17 | Poly(p-methoxyphenyl isopropenyl ketone) | $In(NO_3)_3 \cdot 3H_2O$ [10] | do. | 2 |
| 18 | Phenyl isopropenyl ketone [50] /methyl methacrylate [50] copolymer | $AlCl_3 \cdot 6H_2O$ [10] | Methyl isobutyl ketone [70] /isopropanol [30] | 1 |

TABLE 2 (Continued)

| Compos. No. | Kind of polymer | Additive *[wt.–%] | Developer [vol.–%] | Sensitivity ($\mu C/cm^2$) |
|---|---|---|---|---|
| 19 | Phenyl isopropenyl ketone [50] /methyl methacrylate [50] copolymer | $CoCl_2 \cdot 6H_2O$ [10] | Methyl isobutyl ketone [70] /isopropanol [30] | 1 |
| 20 | do. | $CuCl_2 \cdot 2H_2O$ [10] | do. | 1,5 |
| 21 | do. | $NiCl_2 \cdot 2H_2O$ [10] | do. | 1 |
| 22 | do. | $MnCl_2 \cdot 4H_2O$ [10] | do. | 2 |
| 23 | do. | $CrCl_3 \cdot 6H_2O$ [10] | do. | 1,5 |
| 24 | do. | $Al(NO_3)_3 \cdot 9H_2O$ [10] | do. | 1 |
| 25 | do. | $Zn(NO_3)_2 \cdot 6H_2O$ [10] | do. | 1 |
| 26 | do. | $Fe(NO_3)_3 \cdot 9H_2O$ [10] | do. | 1,5 |
| 27 | do. | $Mn(NO_3)_2 \cdot 6H_2O$ [10] | do. | 2 |

Comparative Example 1

Similarly to Example 1, polymers shown in Table 3 were obtained by radical polymerization at 80°C for 10 h by using azobisisobutyronitrile as a polymerization initiator. The polymers were recovered similarly to the Examples mentioned above and were dissolved in toluene to give 10% by weight solutions. Each polymer solution obtained was applied on to a silicon wafer by spin coating to give a polymer film of about 1 μm thickness.

Subsequently, the sensitivity of these polymer films to an electron beam at an acceleration voltage of 15 kV was determined. Also, the ion etching rate of the polymer films was measured by ion etching under argon gas. The results were shown in Table 3. They show that the polymers of this comparative example were all poor in radiation sensitivity and also in dry etching resistance, and hence these polymers were not suited for practical application.

TABLE 3

| Polymer No. | Kind of polymer | Molecular weight | Developer | Sensitivity ($\mu C$ /cmX) | Ion etching rate (nm /min) |
|---|---|---|---|---|---|
| 28 | Phenyl isopropenyl ketone [5] /methyl methacrylate [95] copolymer | 100.000 | Methyl isobutyl ketone /isopropanol (35 /65 by volume) | 30 | 30 |
| 29 | Phenyl isopropenyl ketone [2]·/methyl methacrylate [98] copolymer | 150.000 | do. | 70 | 37 |

Comparative Example 2

Similarly to the examples mentioned above polymers shown in Table 4 were obtained by radical polymerization at 60°C for 10 h using azobisisobutyronitrile as a polymerization initiator. The polymers obtained were recovered similarly to the examples mentioned above and the polymers were dissolved in toluene to give 10% by weight solutions. To these solutions was added an additive in a predetermined quantity to give compositions 30 to 32 shown in Table 4. Each composition was applied on to a silicon wafer by spin coating to give a polymer film of about 1 µm thickness.

Subsequently, the sensitivity of each film to an electron beam of 20 kV acceleration voltage was determined. The results are shown in Table 4. As is clear from the table, these films were all poor in radiation sensitivity and could not be practically used.

TABLE 4

| Compos. No. | Kind of polymer | Additive [wt. %] | Developer [vol.—%] | Sensitivity ($\mu C/cm^2$) |
|---|---|---|---|---|
| 30 | Phenyl isopropenyl ketone [5] /methyl methacrylate [95] copolymer | $In(NO_3)_3 \cdot 3H_2O$ [0.05] | Methyl isobutyl ketone [35] /isopropyl alcohol [65] | 30 |
| 31 | Phenyl isopropenyl ketone [2] /methyl methacrylate [98] copolymer | $In(NO_3)_3 \cdot 3H_2O$ [30] | do. | >100 |
| 32 | do. | $PdCl_2 \cdot 2H_2O$ [0.05] | do. | >100 |

**Claims**

1. Radiation sensitive polymers comprising
(A) repeating units derived from an aryl isopropenyl ketone
and possibly
(B) repeating units derived from a copolymerizable vinyl monomer, characterized by
— 10 to 100 mole-% of one or more repeating units (A) of the formula I

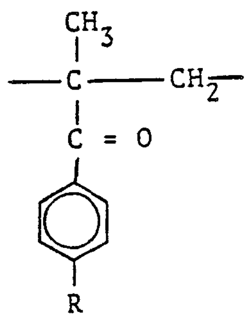

(I),

wherein R is H, $-CH_3$, $-OCH_3$, Cl, Br, J or $-N(CH_3)_2$,
and
— 90 to 0 mole-% repeating units (B) derived from methacrylic acid, methyl, methacrylate, methacrylonitrile of methyl isopropenyl ketone.

2. Radiation sensitive polymer compositions, characterized by
(1) 80 to 99,9 % by weight of a polymer according to claim 1 and
(2) 0,1 to 20% by weight of $AlCl_3 \cdot 6H_2O$, $CaCl_2 \cdot 6H_2O$, $CoCl_2 \cdot 6H_2O$, $FeCl_3 \cdot 6H_2O$, $CuCl_2 \cdot 2H_2O$, $NiCl_2 \cdot 2H_2O$, $PdCl_2 \cdot 2H_2O$, $MnCl_2 \cdot 4H_2O$, $CrCl_3 \cdot 6H_2O$, $Al(NO_3)_3 \cdot 9H_2O$, $Zn(NO_3)_2 \cdot 6H_2O$, $In(NO_3)_3 \cdot 3H_2O$, $Ca(NO_3)_2 \cdot 4H_2O$, $Cr(NO_3)_3 \cdot 9H_2O$, $Co(NO_3)_2 \cdot 6H_2O$, $Fe(NO_3)_3 \cdot 9H_2O$, $Cu(NO_3)_2 \cdot 3H_2O$, $Ni(NO_3)_2 \cdot 6H_2O$ or $Mn(NO_3)_2 \cdot 6H_2O$.

3. Polymer compositions according to claim 2, characterized by
— 90 to 99,9 % by weight of component (1)
and
— 0,1 to 10 % by weight of component (2).

4. Polymer compositions according to claim 2 or 3, further characterized by an organic solvent.

**Patentansprüche**

1. Strahlungsempfindliche Polymere auf der Basis von
(A) sich wiederholenden, von einem Arylisopropenylketon abstammenden Einheiten und möglicherweise
(B) sich wiederholenden, von einem copolymerisierbaren Vinylmonomer abstammenden Einheiten, gekennzeichnet durch
—10 bis 100 mol% einer oder mehrerer sich wiederholender Einheiten (A) der Formel I

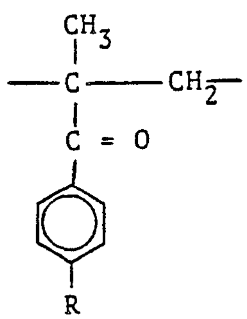

(I),

in der R H, $-CH_3$, $-OCH_3$, Cl, Br, J oder $-N(CH_3)_2$ bedeutet,
und
—90 bis 0 mol% sich wiederholender, von Methacrylsäure, Methylmethacrylat, Methacrylnitril oder Methylisopropenylketon abstammenden Einheiten (B).

2. Strahlungsempfindliche Polymerzusammensetzungen, gekennzeichnet durch
(1) 80 bis 99,9 Gew.% eines Polymers gemaß Anspruch 1 und

(2) 0,1 bis 20 Gew.% $AlCl_3 \cdot 6H_2O$, $CaCl_2 \cdot 6H_2O$, $CoCl_2 \cdot 6H_2O$, $FeCl_3 \cdot 6H_2O$, $CuCl_2 \cdot 2H_2O$, $NiCl_2 \cdot 2H_2O$, $PdCl_2 \cdot 6H_2O$, $MnCl_2 \cdot 4H_2O$, $CrCl_3 \cdot 6H_2O$, $Al(NO_3)_3 \cdot 9H_2O$, $Zn(NO_3)_2 \cdot 6H_2O$, $In(N0_3)_3 \cdot 3H_2O$, $Ca(NO_3)_2 \cdot 4H_2O$, $Cr(NO_3)_3 \cdot 9H_2O$, $Co(NO_3)_2 \cdot 6H_2O$, $Fe(NO_3)_3 \cdot 9H_2O$, $Cu(NO_3)_2 \cdot 3H_2O$, $Ni(NO_3)_2 \cdot 6H_2O$ oder $Mn(NO_3)_2 \cdot 6H_2O$.

3. Polymerzusammensetzungen nach Anspruch 2, gekennzeichnet durch

—90 bis 99,9 Gew.% der Komponente (1)

und

—0,1 bis 10 Gew.% der Komponente (2).

4. Polymerzusammensetzungen nach Anspruch 2 oder 3 weiter gekennzeichnet durch ein organisches Lösungsmittel.

**Revendications**

1. Matériau polymère sensible aux radiations comprenant

(A) une répétition d'unités dérivées d'un aryl-isopropényle de cétone

et éventuellement

(B) une répétition d'unités dérivées d'un monomère copolymérisable de vinyle

caractérisé par

—un pourcentage molaire compris entre 10% et 100% de l'une ou plusieurs des unités répétées (A) de formule I

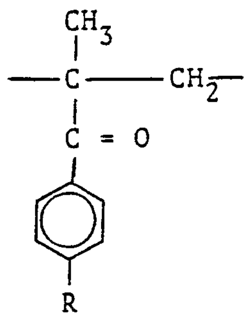

(I),

dans laquelle R est H, $-CH_3$, $-OCH_3$, Cl, Br, J ou $-N(CH_3)_2$, et

—un pourcentage molaire compris entre 90% et 0% des unités répétées (B) dérivées d'acide métacrylique, de métacrylate de méthyle, de métacrylonitrile ou de méthyl-isopropényle de cétone.

2. Matériau polymère sensible aux radiations

caractérisé par

(1) 80 à 99,9% en poids d'un polymère selon la revendication 1 et

(2) 0,1 à 20% poids de $AlCl_3 \cdot 6H_2O$, $CaCl_2 \cdot 6H_2O$, $CoCl_2 \cdot 6H_2O$, $FeCl_3 \cdot 6H_2O$, $CuCl_2 \cdot 2H_2O$, $NiCl_2 \cdot 2H_2O$, $PdCl_2 \cdot 2H_2O$, $MnCl_2 \cdot 4H_2O$, $CrCl_3 \cdot 6H_2O$, $Al(NO_3)_3 \cdot 9H_2O$, $Zn(NO_3)_2 \cdot 6H_2O$, $In(N0_3)_3 \cdot 3H_2O$, $Ca(NO_3)_2 \cdot 4H_2O$, $Cr(NO_3)_3 \cdot 9H_2O$, $Co(NO_3)_2 \cdot 6H_2O$, $Fe(NO_3)_3 \cdot 9H_2O$, $Cu(NO_3)_2 \cdot 3H_2O$, $Ni(NO_3)_2 \cdot 6H_2O$ ou $Mn(NO_3)_2 \cdot 6H_2O$.

3. Matériau polymère selon la revendication 2

caractérisé par

—90 à 99,9% en poids composant (1) et

—0,1 à 10% en poids du composant (2)

4. Matériau polymère selon la revendication 2 ou 3 caractérisé en outre par un solvant organique.

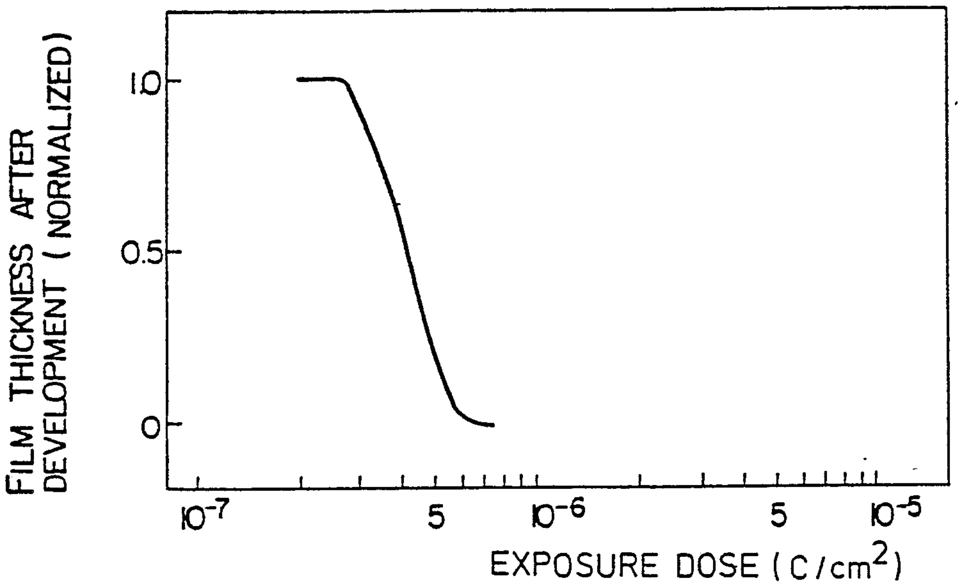
FILM THICKNESS AFTER DEVELOPMENT (NORMALIZED)
1.0
0.5
0
$10^{-7}$
5
$10^{-6}$
5
$10^{-5}$
EXPOSURE DOSE (C/cm$^2$)